# EUROPÄISCHE PATENTSCHRIFT

(11) **EP 1 276 116 B1**
(45) Veröffentlichungstag und Bekanntmachung des Hinweises auf die Patenterteilung: **10.09.2008**
(21) Anmeldenummer: 01117052.9
(22) Anmeldetag: 12.07.2001
(51) Int. Cl.: G11C 16/10, G06F 11/14, G05B 19/042

(54) **Verfahren zur Speicherung zusammengehöriger Datensätze**
Method for storing related data
Méthode pour le stockage de données associées

(43) Veröffentlichungstag der Anmeldung: 15.01.2003
(73) Patentinhaber: SIEMENS AKTIENGESELLSCHAFT, 80333 München (DE)
(72) Erfinder: Böhme, Hagen, Dr., 09235 Burkhardtsdorf (DE); Hammer, Andreas, 09306 Wechselburg (DE); Nagy, Franz, 90429 Nürnberg (DE)

(56) Entgegenhaltungen:
- WO-A-00/77640
- WO-A-01/31458
- FR-A- 2 730 833
- FR-A- 2 742 893
- FR-A- 2 799 046
- US-A- 4 763 305

## Beschreibung

Die Erfindung betrifft ein Verfahren zur Speicherung zusammengehöriger Datensätze nach dem Oberbegriff von Anspruch 1.

Ein derartiges Verfahren ist aus der WO 01/31458 bekannt.

Speichermedien weisen üblicherweise eine Anzahl von Speicherzellen auf, die jeweils geeignet sind, ein Datum zu speichern. Eine einzelne Speicherzelle speichert dabei einen von zumindest zwei möglichen Zuständen und entspricht damit einem so genannten "Bit". Der erste der zumindest zwei möglichen Zustände der Speicherzelle wird als logisch "high" oder kurz mit "1", der zweite der zumindest zwei möglichen Zustände wird als logisch "low" oder kurz mit "0" bezeichnet.

Ein Datum entspricht in seiner einfachsten Form dem Inhalt genau einer Speicherzelle. Häufig werden jedoch mehrere Speicherzellen (mehrere Bits) zusammengefasst und bilden entsprechend einem festgelegten Format ein Datum. So bilden z. B. acht Bit ein so genanntes Byte, wobei diese Folge von Speicherzellen als numerische Darstellung im Binärsystem z. B. ganze Zahlen mit einem Wert von 0 bis 255 darstellen kann. Analog werden auch mehr als acht Bit zu einem Datum zusammengefasst; z. B. sechzehn Bit zu einem so genannten Wort und 32 Bit zu einem so genannten Langwort. Ein Byte, ein Wort, ein Langwort, etc. wird als einfaches Datum oder als einfacher Datentyp bezeichnet.

Über diese einfachen Datentypen hinaus ist es mit heute gängigen Programmiersprachen möglich, so genannte zusammengesetzte Datentypen festzulegen, indem sie als Kombination der einfachen Datentypen oder bereits festgelegter zusammengesetzter Datentypen definiert werden. Ein Beispiel ist ein zusammengesetzter Datentyp zur Speicherung der Uhrzeit, der drei Byte umfasst, wobei das erste Byte zur Speicherung des Wertes für die Stunden, das zweite Byte zur Speicherung des Wertes für die Minuten und das dritte Byte zur Speicherung des Wertes für die Sekunden verwendet wird.

Unter einem Datensatz wird eine Anzahl derartiger Daten, also einfacher und/oder zusammengesetzter Daten, verstanden, die semantisch eine Einheit bilden. Ein Datensatz ist identifizierbar durch eine Kennung (einen Namen oder eine Nummer) und hinsichtlich seiner Länge (seines Datenumfangs) bestimmbar. Bilden mehrere Datensätze eine logische Einheit, so wird diese Einheit nachfolgend als Datenpool bezeichnet.

In einem Gerät, das zur Steuerung und/oder Überwachung eines technischen Prozesses Anwendung findet und nachfolgend auch als Automatisierungsgerät bezeichnet wird, bildet z. B. die Kombination sämtlicher Parameter dieses Gerätes einen Datensatz. Ggf. werden auch funktional oder inhaltlich zusammengehörige Parameter in einem separaten Datensatz zusammengefasst, so dass sich mehrere Datensätze ergeben. Eine Gruppe von Datensätzen bildet dann einen Datenpool. Ein Parameter eines solchen Gerätes ist z. B. die so genannte Netzwerkadresse, wenn das Gerät im Verbund mit weiteren Automatisierungsgeräten betrieben wird und über diese Netzwerkadresse gezielt Daten von anderen Geräten übermittelt bekommt oder anderen Geräten anhand deren Adresse Daten übermittelt. Ein weiterer Parameter ist häufig eine Kennung des Gerätes selbst, anhand derer andere Automatisierungsgeräte, die diese Kennung abfragen, Informationen über die Funktionalität des Gerätes erhalten können.

Alle Parameter eines Gerätes bilden eine semantische Einheit und werden daher häufig in einem Datensatz zusammengefasst, damit auf einfache Weise auf sämtliche Parameter zugegriffen werden kann. Dass aufgrund der Zusammenfassung in einem Datensatz quasi gleichzeitig auf sämtliche Parameter zugegriffen werden kann, ist bei Kopier- oder Transferfunktionen, etwa bei der Erstellung einer Kopie des Datensatzes, besonders vorteilhaft.

Bei mehreren Automatisierungsgeräten, die z. B. im Verbund betrieben werden, ergibt sich für jedes einzelne Gerät mindestens ein Datensatz mit Parameterdaten. Die Kombination sämtlicher Datensätze mit Parameterdaten bildet den entsprechenden Datenpool.

Beim bloßen Kopieren aller Datensätze eines Datenpools in einen Zielspeicher oder einen Zielspeicherbereich können sich in Bezug auf die Konsistenz des neu geschriebenen Datenpools Probleme ergeben. Wird z. B. das Kopieren eines Datenpools unterbrochen, zum Beispiel durch Spannungsausfall oder durch Ausfall des Kommunikationsweges zwischen dem bisherigen Speicherort des Datenpools oder dem bisherigen Speicherort einzelner Datensätze des Datenpools und dem Zielspeicher, so ist die Konsistenz des neu geschriebenen Datenpools a priori nicht gewährleistet.

Zwar besteht die Möglichkeit, zusammengehörige Datensätze zu kennzeichnen. So kann beispielsweise jeder Datensatz mit einem Ausgabestand gekennzeichnet werden, wobei alle Datensätze eines Datenpools den gleichen Ausgabestand erhalten. Auch können alle Datensätze eines Datenpools unmittelbar hintereinander liegend abgespeichert und mit einer Hülle gekennzeichnet werden.

Bei dem aus der WO 01/31458 bekannten Verfahren zur Speicherung zusammengehöriger Datensätze in einem Zielspeicher sind in dem Zielspeicher noch alte Datensätze einer zurückliegenden Sicherung vorhanden, wobei im Zielspeicher jeder Datensatz ein Attribut aufweist. Das Attribut eines jeden alten Datensatzes im Zielspeicher hat entweder einen ersten Wert "V = Valid" oder einen zweiten Wert "D = Dirty". Beim Transfer von Datensätzen in den Zielspeicher wird das Attribut eines jeden neu geschriebenen Datensatzes auf einen dritten Wert "W = Written" oder "T = TransactionWritten) gesetzt. Zu jedem neu geschriebenen Datensatz wird der zugehörige alte Datensatz mit einem Attribut mit dem ersten Wert "V = Valid" gesucht und das Attribut des dabei gefundenen alten Datensatzes auf den zweiten Wert "D = Dirty" sowie das Attribut des jeweils neu geschriebenen Datensatzes auf den ersten Wert "V = Valid" gesetzt.

Nachteilig ist jedoch, dass für den Fall einer Unterbrechung des Kopiervorgangs dieser zeit- und speicherplatzaufwendig erneut durchgeführt werden muss und - unabhängig von tatsächlich vorliegenden Änderungen der Dateninhalte - alle Datensätze vollständig neu geschrieben werden, weil nicht erkennbar ist, wann der Aktualisierungsvorgang abgeschlossen ist.

Der Erfindung liegt daher die Aufgabe zugrunde, ein Verfahren zur konsistenten Speicherung zusammengehöriger Datensätze anzugeben, mit dem gewährleistet ist, dass unabhängig von möglichen Unterbrechungen zu jedem Zeitpunkt ein vollständiger und in sich konsistenter Datenpool existiert und nutzbar ist. Zudem sollen - bedingt durch die Besonderheiten beim Zugriff auf einen Flash-Speicher - Schreib- und Löschvorgänge minimiert werden.

Diese Aufgabe wird erfindungsgemäß gelöst durch die Merkmale des Anspruchs 1.

Gegenstand der Erfindung ist somit ein Verfahren zur Speicherung zusammengehöriger Datensätze in einem Zielspeicher, bei dem im Zielspeicher noch alte Datensätze einer zurückliegenden Sicherung vorhanden sind, und bei dem im Zielspeicher jeder Datensatz ein Attribut aufweist,
- wobei das Attribut eines jeden alten Datensatzes im Zielspeicher entweder einen ersten Wert (USED) oder einen zweiten Wert (ERASED) hat und
- wobei beim Transfer von Datensätzen in den Zielspeicher das Attribut eines jeden neu geschriebenen Datensatzes auf einen dritten Wert (INTERIM) gesetzt wird und
- wobei im Anschluss an den Transfer aller Datensätze in den Zielspeicher zunächst das Attribut eines der neu geschriebenen Datensätze, des Startdatensatzes, auf einen vierten Wert (VALID) gesetzt wird, und
- wobei zu jedem neu geschriebenen Datensatz der zugehörige alte Datensatz mit einem Attribut mit dem ersten Wert (USED) gesucht wird und das Attribut des dabei gefundenen alten Datensatzes auf den zweiten Wert (ERASED) sowie das Attribut des jeweils neu geschriebenen Datensatzes auf den ersten Wert (USED) gesetzt wird und,
- wobei erst dann zu jedem zusätzlich zum Startdatensatz verbleibenden neu geschriebenen Datensatz der zugehörige alte Datensatz mit dem Attribut mit dem ersten Wert (USED) gesucht wird und das Attribut des dabei gefundenen alten Datensatzes auf den zweiten Wert (ERASED) wobei das Attribut des jeweils neu geschriebenen Datensatzes auf den ersten Wert (USED) gesetzt wird, und
- zuletzt zu dem Startdatensatz der zugehörige alte Datensatz mit dem Attribut mit dem ersten Wert (USED) gesucht wird und das Attribut des dabei gefundenen alten Datensatzes auf den zweiten Wert (ERASED) sowie das Attribut des Startdatensatzes auf den ersten Wert (USED) gesetzt wird.

Beim Transfer eines Datensatzes in den Zielspeicher wird das Attribut eines jeden neu geschriebene Datensatzes auf einen dritten Wert gesetzt. Dieser dritte Wert wird mit dem Bezeichner INTERIM referenziert. Nach dem Transfer aller Datensätze in den Zielspeicher wird das Attribut eines der neu geschriebenen Datensätze - eines Startdatensatzes - auf einen vierten Wert gesetzt. Dieser vierte Wert wird mit dem Bezeichner VALID referenziert. Der Transfer der Datensätze wird auch als Aktualisierungsvorgang bezeichnet. Das Verfahren ist hinsichtlich des benötigten Speicherplatzes und des Zeitbedarfs optimiert.

Gemäß der Erfindung wird somit durch einen speziellen Attributwechsel der Abschluss des Aktualisierungsvorgangs angezeigt. Dieser spezielle Attributwechsel ist der Wechsel des Attributs des Startdatensatzes. Dieser erfolgt gemäß dem Verfahren erst dann, wenn sämtliche zu sichernden Datensätze in den Zielspeicher transferiert wurden. Besonders vorteilhaft ist, dass die Konsistenz aller Datensätze des Datenpools auch dann gesichert ist, wenn der Aktualisierungsvorgang unterbrochen wird. Der verwendbare Datenpool ist entweder der neu geschriebene Datenpool oder - falls noch nicht alle Datensätze des neuen Datenpools geschrieben werden konnten - der bisher gültige Datenpool. Zu jedem Zeitpunkt des Aktualisierungsvorgangs steht ein vollständiger Pool von Datensätzen zur Verfügung.

Vorteilhafte Ausgestaltungen der Erfindung sind Gegenstand der Unteransprüche.

Das Attribut eines bereits im Zielspeicher vorhandenen Datensatzes hat entweder einen ersten oder zweiten Wert. Der erste Wert wird mit dem Bezeichner USED und der zweite Wert mit dem Bezeichner ERASED referenziert. Zu jedem neben dem Startdatensatz verbleibenden neu geschriebenen Datensatz wird der zugehörige alte Datensatz mit einem Attribut mit dem ersten Wert gesucht, das Attribut eines jeden dabei gefundenen alten Datensatzes auf den zweiten Wert und das Attribut eines jeden der verbliebenen neu geschriebenen Datensätze auf den ersten Wert gesetzt. Schließlich wird zu dem Startdatensatz der zugehörige alte Datensatz mit einem Attribut mit dem ersten Wert gesucht, das Attribut des dabei gefundenen alten Datensatzes auf den zweiten Wert und das Attribut des Startdatensatzes auf den ersten Wert gesetzt.

Auf diese Weise können durch einen einfachen Wechsel der Attribute die nicht mehr aktuellen Datensätze einer zurückliegenden Sicherung quasi deaktiviert werden. Die deaktivierten Datensätze sind im Zielspeicher zwar noch vorhanden, werden aber nicht mehr berücksichtigt. Ein ggf. vorgesehenes Löschen der durch diese Datensätze belegten Speicherzellen kann durchgeführt werden, wenn das Verfahren beendet ist und bevor das Verfahren erneut gestartet wird. Dies führt dazu, dass die Dauer des Verfahrens nicht von der Zeit, die das Löschen solcher Datensätze erfordert, abhängig ist.

Das erfindungsgemäße Verfahren ist darüber hinaus speicherplatzsparend und noch auf andere Weise zeitsparend. Gemäß einer vorteilhaften Ausgestaltung des Verfahrens werden nur diejenigen Datensätze neu geschrieben, die einen veränderten Inhalt zur bereits im Speicher gültig vorliegenden Version aufweisen, ohne dabei die Konsistenzwahrung zu gefährden. Sparsamer Umgang mit Speicherplatz verzögert das Füllen des Zielspeichers. Wenn der Zielspeicher ein Flash-Speicher ist, verschiebt dies den Zeitpunkt des zeitaufwendigen Löschvorgangs. Nach dem Aktualisierungsvorgang existiert ein konsistenter Datenpool, der sich aus unveränderten, bereits vor der Aktualisierung gespeicherten Datensätzen und veränderten, neu geschriebenen Datensätzen zusammensetzt.

Dazu ist vorgesehen, dass der Transfer eines Datensatzes in den Zielspeicher nur dann erfolgt, wenn der zu transferierende Datensatz Unterschiede zu seinem bereits im Zielspeicher gespeicherten Pendant aufweist. Die Verwendung der Attribute für jeden Datensatz im Zielspeicher erleichtert auch einen derartigen selektiven Transfer nur der veränderten Datensätze. Damit muss nämlich nicht etwa eine bestimmte Reihenfolge der Datensätze im Zielspeicher eingehalten werden, um zu erkennen, welcher Datensatz aktuell ist und welcher Datensatz von einer zurückliegenden Sicherung stammt.

Das Erkennen der zu transferierenden Datensätze wird erleichtert, wenn jeder Datensatz im Zielspeicher eine Kennung aufweist, wobei vor dem Transfer eines Datensatzes in den Zielspeicher für diesen gleichfalls eine Kennung gebildet wird, und wobei der Transfer des Datensatzes in den Zielspeicher nur erfolgt, wenn die gebildete Kennung von der Kennung des bereits im Zielspeicher gespeicherten Pendants des zu transferierenden Datensatzes abweicht. Zu diesem Zweck muss anhand der Kennung eine Veränderung des Datensatzes ersichtlich sein. Ein Beispiel für eine solche Kennung ist eine so genannte CRC-Signatur, die nach einem definierten Algorithmus aus den im Datensatz enthaltenen Daten gebildet wird. Ein weiteres Beispiel für eine solche Kennung ist eine Kennung, die aus dem Zeitpunkt, z. B. Datum und Uhrzeit, des letzten Schreibzugriffs auf die Daten des Datensatzes gebildet wird.

Gemäß einer bevorzugten Ausgestaltung der Erfindung ist vorgesehen, dass der Zielspeicher ein Flash-Speicher ist. Dann sind die Datensätze, sobald sie in den Zielspeicher übertragen sind, optimal gegen Spannungsausfälle gesichert, da in einem Flash-Speicher die Daten auch im spannungslosen Zustand erhalten bleiben.

Ein Flash-Speicher weist die Besonderheit auf, dass durch einen einzelnen Schreibvorgang eine Speicherzelle nur vom Status 1 auf den Status 0 geändert werden kann, und dass das Löschen einer Speicherzelle deutlich mehr Zeit erfordert als das Schreiben. Vor diesem Hintergrund wird eine weitere Steigerung der Geschwindigkeit des erfindungsgemäßen Verfahrens erreicht, indem die Werte der Attribute so gewählt sind, dass sich der dritte Wert des Attributs vom vierten Wert, der vierte Wert vom ersten Wert und der erste Wert vom zweiten Wert stets durch mindestens eine ganzzahlige Potenz von Zwei unterscheidet. Auf diese Weise kann zwischen zwei Werten eines Attributs gewechselt werden, indem einzelne Speicherzellen des von dem jeweiligen Attribut belegten Speicherplatzes durch einen gezielten Schreibvorgang vom Status "1" auf den Status "0" geändert werden.

Eine besonders vorteilhafte Wahl des ersten, zweiten, dritten und vierten Wertes besteht darin, dass der vierte Wert des Attributs in Bezug auf den dritten Wert, der erste Wert des Attributs in Bezug auf den vierten Wert und der zweite Wert des Attributs in Bezug auf den ersten Wert jeweils um eine ganzzahlige Potenz von Zwei kleiner ist.

Eine alternative Möglichkeit zur Wahl des ersten, zweiten, dritten und vierten Wertes besteht darin, dass der vierte Wert des Attributs in Bezug auf den dritten Wert, der erste Wert des Attributs in Bezug auf den vierten Wert und der zweite Wert des Attributs in Bezug auf den ersten Wert jeweils um eine ganzzahlige Potenz von Zwei größer ist.

Das Verfahren lässt sich analog auch zur Sicherung mehrerer zusammengehöriger Datenpools - etwa auf eine Festplatte o.ä. - verwenden, denn genau wie der Datensatz eine Kombination von Daten darstellt, ergibt sich der Datenpool als Kombination von Datensätzen. Entsprechend lässt sich das Verfahren auf die Sicherung von Datenpools übertragen, wenn der Datenpool ein Attribut aufweist und die Speicherung zusammengehöriger Datenpools analog zur Speicherung zusammengehöriger Datensätze - wie vorstehend beschrieben - erfolgt.

Nachfolgend wird ein Ausführungsbeispiel der Erfindung anhand der Zeichnung näher erläutert. Darin zeigen:
- FIG 1: schematisch ein Automatisierungssystem,
- FIG 2: den lokalen Speicher eines Automatisierungsgerätes,
- FIG 3: den lokalen Speicher eines Parametrierservers, und
- FIG 4a-4g: den lokalen Speicher von Automatisierungsgerät und Parametrierserver während eines Aktualisierungsvorgangs.

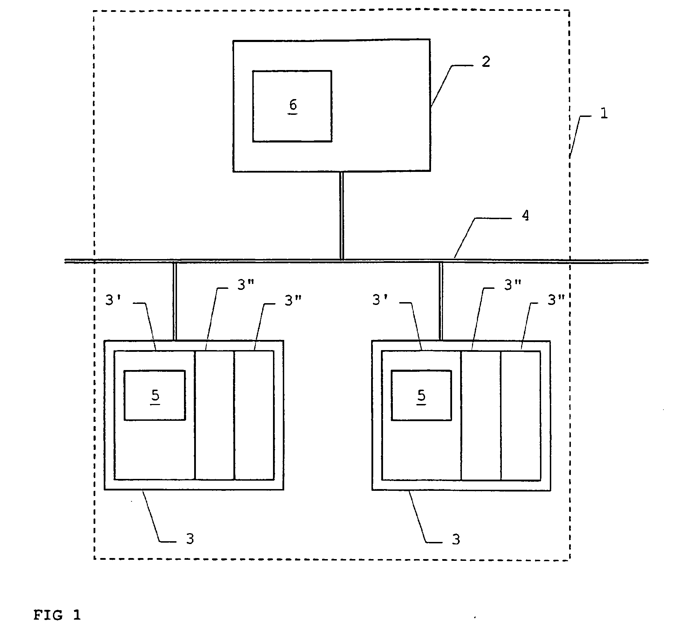

FIG 1 zeigt ein Automatisierungssystem 1 mit einem ersten elektrischen Gerät 2 und weiteren elektrischen Geräten 3, die über einen Bus 4 kommunikativ miteinander verbunden sind. Der Bus 4 ist z. B. ein geräteinterner Bus oder auch ein so genannter Feldbus. Jedes Gerät 2, 3 weist einen lokalen Speicher 5, 6 auf, in dem zumindest Parametrierdaten gespeichert sind.

Das erste elektrische Gerät 2 speichert in seinem lokalen Speicher 6 die Parametrierdaten aller anderen elektrischen Geräte 3. Das erste elektrische Gerät 2 wird daher auch als Parametrierserver bezeichnet. Die Speicherung der Parametrierdaten im lokalen Speicher 6 des Parametrierservers 2 soll auch nach einem Spannungsausfall erhalten bleiben. Deshalb ist der lokale Speicher 6 des Parametrierservers 2 als Flash-Speicher ausgeführt.

Ein Flash-Speicher zeichnet sich durch folgende Eigenschaften aus:
- spannungsausfallsichere Speicherung von Daten;
- Aufteilbarkeit des Speichers 6 in unabhängig voneinander löschbare Sektoren;
- prinzipielle aber eingeschränkte Wiederbeschreibbarkeit des Speichers, insofern, als durch einen Schreibvorgang eine einzelne Speicherzelle nur vom Wert 1 auf den Wert 0 geändert werden kann;
- die bedingungslose Wiederbeschreibbarkeit des Flash-Speichers bzw. eines Sektors desselben ist erst nach einem Löschvorgang gegeben, bei dem jede Speicherzelle des Flash-Speichers bzw. eines Sektors den Wert 1 erhält;
- der Löschvorgang zeichnet sich im Vergleich zum Schreibvorgang durch einen signifikant höheren Zeitbedarf aus,
- ein Lesezugriff ist signifikant schneller als ein Schreibzugriff.

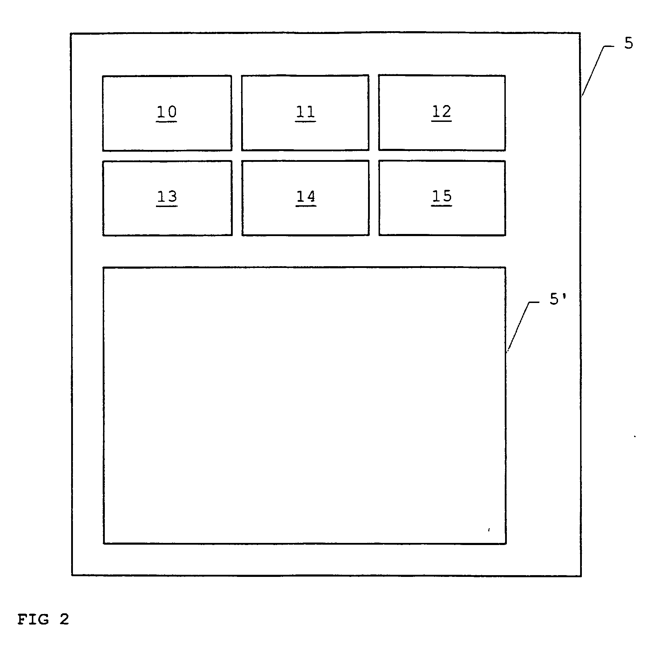

Die weiteren elektrischen Geräte 3 sind in nicht näher dargestellter Art und Weise zur Steuerung und/oder Überwachung eines technischen Prozesses, wie z. B. einer Pressensteuerung, vorgesehen. Die weiteren elektrischen Geräte 3 werden daher auch als Automatisierungsgeräte bezeichnet. Jedes Automatisierungsgerät 3 weist eine Zentraleinheit 3' und weitere Funktionsmodule 3" auf. Der lokale Speicher 5 des Automatisierungsgerätes 3 ist in der Zentraleinheit 3' vorgesehen. Die Zentraleinheit 3' weist einen (nicht dargestellten) Prozessor auf, der zur Steuerung und/oder Überwachung des technischen Prozesses ein Steuerprogramm 5' (FIG 2) abarbeitet.

FIG 2 zeigt den lokalen Speicher 5 eines der Automatisierungsgeräte 3. In dem lokalen Speicher 5 ist das Steuerprogramm 5' abgelegt. Ferner sind im lokalen Speicher 5 ein erster, zweiter, dritter, vierter, fünfter und sechster Datensatz 10, 11, 12, 13, 14 bzw. 15 abgelegt. Die Datensätze 10 bis 15 enthalten die Parametrierdaten des Automatisierungsgerätes 3. Der erste Datensatz 10 enthält dabei z. B. die Parametrierdaten für die Kommunikation über den Bus 4, wie z. B. eine Datentransferrate, eine eindeutige Adresse, etc. Der zweite Datensatz 11 enthält z. B. die Parametrierdaten der Zentraleinheit 3'. Der dritte und vierte Datensatz 12, 13 enthalten z. B. Parametrierdaten der angeschlossenen Funktionsmodule 3" usw.

Die Parametrierdaten der Automatisierungsgeräte 3, d. h. die Datensätze 10 bis 15, sollen auch im Falle eines Spannungsausfalls erhalten bleiben. Dazu werden diese im Flash-Speicher 6 des Parametrierservers 2 gesichert. Der Vorgang des Übertragens oder Sicherns der Datensätze 10 bis 15 eines Automatisierungsgerätes 3 wird als Aktualisierungsvorgang bezeichnet.

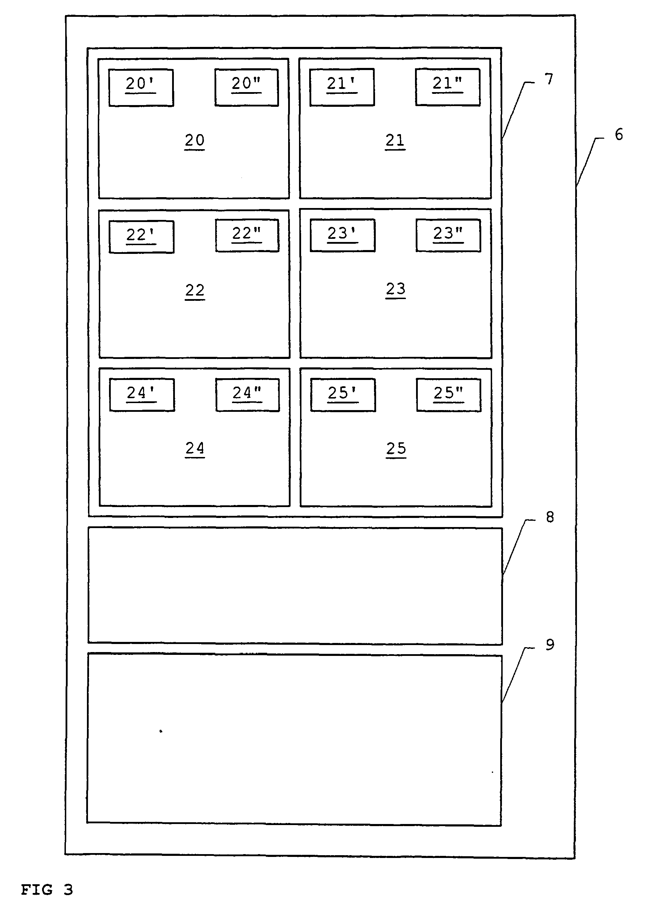

FIG 3 zeigt den Flash-Speicher 6 mit einem darin gespeicherten Datenpool 7 und einem ersten und zweiten weiteren Datenpool 8 bzw. 9. Der Datenpool 7 umfasst einen ersten, zweiten, dritten, vierten, fünften und sechsten Datensatz 20, 21, 22, 23, 24 bzw. 25. Jeder Datensatz 20 bis 25 weist eine Kennung 20', 21', 22', 23', 24', 25' und ein Attribut 20", 21", 22", 23", 24" bzw. 25" auf. Die Kennung 20' bis 25' bildet einen Datensatzkopf, der insbesondere die Länge des Datensatzes 20 bis 25 ausweist. Gemäß einer alternativen Ausgestaltung kann das Attribut 20" bis 25" auch Bestandteil der Kennung 20' bis 25' sein.

Je nach Wert kennzeichnet das Attribut 20" bis 25"
- einen gültigen Datensatz 20 bis 25 (Attribut USED),
- einen ungültigen Datensatz 20 bis 25 (Datensatz einer zurückliegenden Sicherung; Attribut ERASED),
- einen neu geschriebenen, aber noch nicht gültig erklärten Datensatz 20 bis 25 (Attribut INTERIM) oder
- einen neu geschriebenen, aber noch nicht gültig erklärten Datensatz, sofern alle Datensätze 20 bis 25 des Datenpools 7 im Aktualisierungsvorgang betrachtet wurden (Attribut VALID) .

Die Wertzuweisung für die Codierungen der Attribute 20" bis 25" eines Datensatzes 20 bis 25 wird gezielt vorgenommen. Die gezielte Wertzuweisung ermöglicht es, dass das Attribut 20" bis 25" eines im Flash-Speicher 6 gespeicherten Datensatzes 20 bis 25 ohne Löschvorgang wiederholt beschreibbar ist.

Dabei ist folgende Schreibreihenfolge der Attributwerte zu gewährleisten:
INTERIM,
VALID,
USED,
ERASED

Besonders vorteilhaft werden dabei für die Attribut-Kennzeichnungen als Bytewert Codierungen der folgenden Art gewählt:
- INTERIM = 0xEE = 0b 1110 1110
- VALID = 0xCC = 0b 1100 1100
- USED = 0x88 = 0b 1000 1000
- ERASED = 0x00 = 0b 0000 0000.

Der Datenpool 7 enthält z. B. die Parametrierdaten eines der Automatisierungsgeräte 3 (FIG 1), insbesondere die Parametrierdaten genau eines Automatisierungsgerätes 3. Der erste und zweite weitere Datenpool 8 bzw. 9 enthält entsprechend die Parametrierdaten weiterer Automatisierungsgeräte 3. Jeder Datensatz 20 bis 25 des Datenpools 7 - bzw. entsprechende (nicht dargestellte) Datensätze im weiteren Datenpool 8, 9 - enthält Parametrierdaten eines Moduls 3', 3" des betreffenden Automatisierungsgerätes 3. Der erste Datensatz 20 im Flash-Speicher 6 ist das gesicherte Pendant des ersten Datensatzes 10 (FIG 2) im lokalen Speicher 5 (FIG 1) eines der Automatisierungsgeräte 3. Der zweite Datensatz 21 im Flash-Speicher korrespondiert mit dem zweiten Datensatz 11 (FIG 2) im lokalen Speicher 5 des Automatisierungsgerätes 3 usw.

Wenn im lokalen Speicher 5 (FIG 2) die Parametrierdaten eines Automatisierungsgerätes 3 und damit die Inhalte eines oder mehrerer der Datensätze 10 bis 15 geändert werden, sind diese Änderungen bei einem Ausfall der Versorgungsspannung dieses Automatisierungsgerätes 3 üblicherweise verloren. Um die Parametrierdaten dauerhaft zu sichern, werden sie in dem Flash-Speicher 6 des Parametrierservers 2 gespeichert.

Wenn es allerdings während der Übertragung der Parametrierdaten aus dem lokalen Speicher 5 eines der Automatisierungsgeräte 3 in den Flash-Speicher 6 zu Komplikationen kommt, ist die Integrität der Daten üblicherweise nicht gewährleistet. Eine mögliche Komplikation ist z. B. ein Spannungsausfall während der Übertragung der zu sichernden Parametrierdaten. In einem solchen Fall sind üblicherweise die Parametrierdaten des von dem Spannungsausfall betroffenen Automatisierungsgerätes 3 verloren und die an den Parametrierserver 2 übertragenen Daten noch unvollständig und daher auch nicht verwertbar. Erschwerend kommt hinzu, dass auf dem Parametrierserver 2 vor dem Übertragungsvorgang eine verwertbare Kopie ehemaliger Parametrierdaten bestanden haben kann und diese im Zuge der Übertragung und Speicherung der neuen Parametrierdaten überschrieben wurde und damit gleichfalls unbrauchbar ist.

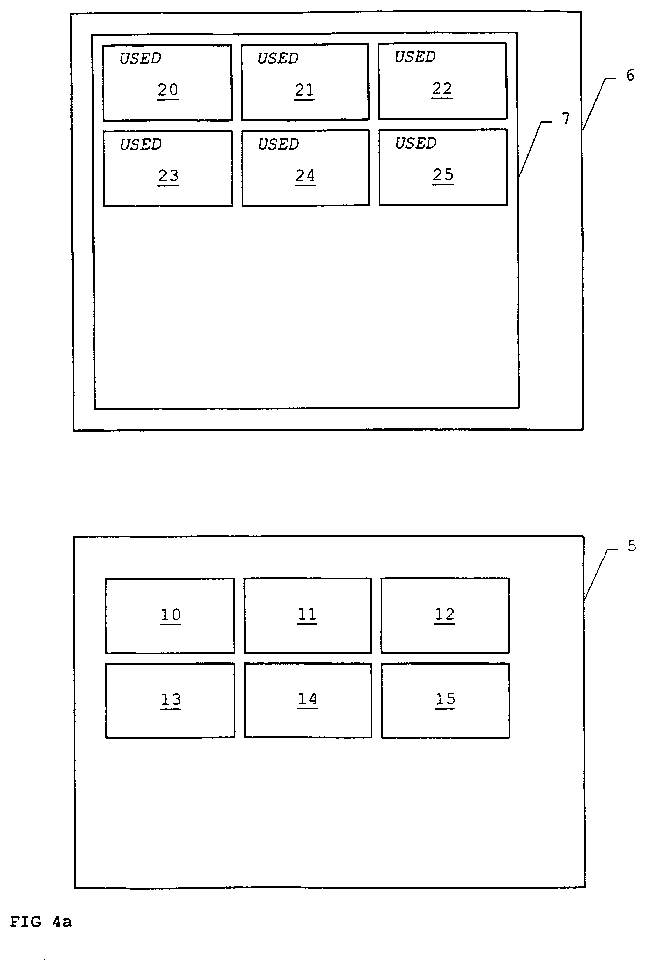

Anhand der Figuren 4a bis 4g wird das Verfahren zur Sicherung der Parametrierdaten eines der Automatisierungsgeräte 3 beschrieben, das derartige Nachteile vermeidet und stets die Konsistenz eines Datenpools auf dem Parametrierserver 2 gewährleistet.

FIG 4a zeigt im statisch stabilen Zustand den Inhalt des Flash-Speichers 6 mit den darin gespeicherten Datensätzen 20 bis 25 sowie den Inhalt des lokalen Speichers 5 eines der Automatisierungsgeräte 3 mit den dort gespeicherten Datensätzen 10 bis 15. Jeder Datensatz 20 bis 25 im Flash-Speicher 6 ist mit einem Attribut 20" bis 25" (FIG 3) versehen, dessen jeweiliger Wert in FIG 4a - wie auch in den folgenden Figuren - im Klartext dargestellt ist. Zu Beginn des Aktualisierungsvorgangs tragen alle gültigen Datensätze 20 bis 25 des Datenpools 7 das Attribut 20" bis 25" USED. Zusätzlich können im Flash-Speicher 6 alte, nicht mehr gültige Datensätze 20 bis 25 existieren, die das Attribut 20" bis 25" ERASED tragen (nicht dargestellt).

Wird ein Aktualisierungsvorgang gestartet, so wird zunächst jeder Datensatz 10 bis 15 des lokalen Speichers 5 mit seinem bereits im Flash-Speicher 6 gespeicherten Pendant 20 bis 25 inhaltlich verglichen. Identische Datensatzpärchen erfordern keine weitere Aktivität. Dann muss es sich nämlich bei dem im Flash-Speicher 6 gespeicherten Datensatz 20 bis 25 um einen bei einem früheren Aktualisierungsvorgang geschriebenen Datensatz 20 bis 25 handeln, ohne dass in der Zwischenzeit an dem entsprechenden Datensatz im lokalen Speicher 5 eines der Automatisierungsgeräte 3 Änderungen vorgenommen wurden.

Wird ein Datensatz 10 bis 15 mit verändertem Inhalt festgestellt, so wird dieser Datensatz 20 bis 25 in den Flash-Speicher 6 übertragen und dort mit dem Attribut 20" bis 25" INTERIM gekennzeichnet.

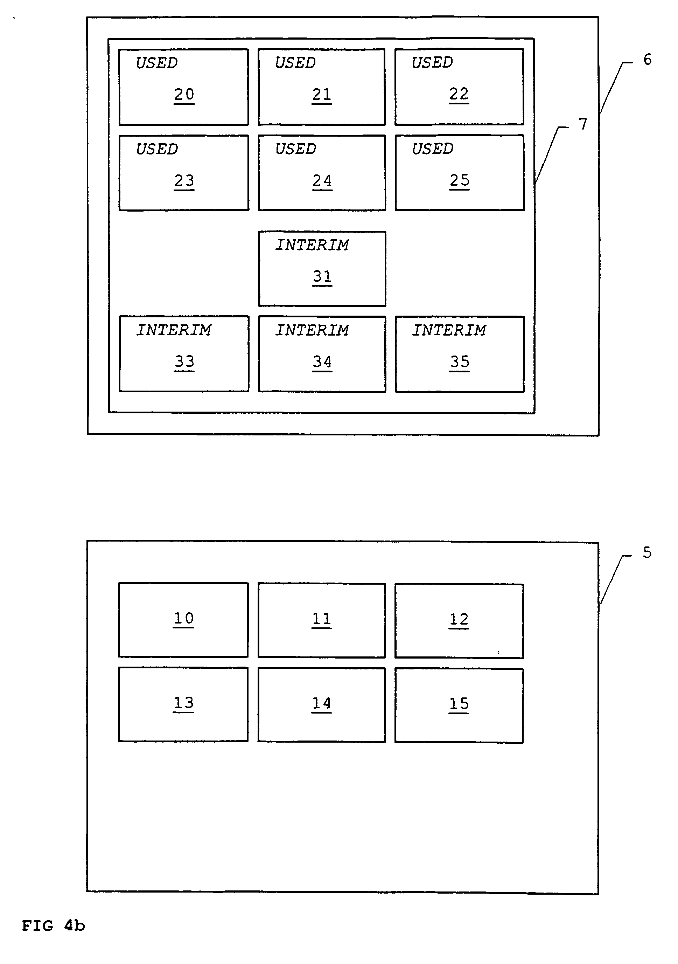

FIG 4b zeigt den Zustand im Flash-Speicher 6 nach diesem Übertragungsvorgang. Zur Verdeutlichung der Details des Verfahrens wurde angenommen, dass der erste und dritte Datensatz 10 bzw. 12 im lokalen Speicher 5 jeweils mit seinem Pendant 20, 22 im Flash-Speicher 6 übereinstimmt und daher nicht mehr gesichert werden muss. Der zweite, vierte, fünfte und sechste Datensatz 11, 13, 14 bzw. 15 wird als verändert angenommen. Diese veränderten Datensätze 11, 13, 14, 15 wurden in den Flash-Speicher 6 kopiert und sind dort jetzt neben den alten Datensätzen 20 bis25 als neu geschriebene Datensätze 31, 33, 34, 35 gespeichert.

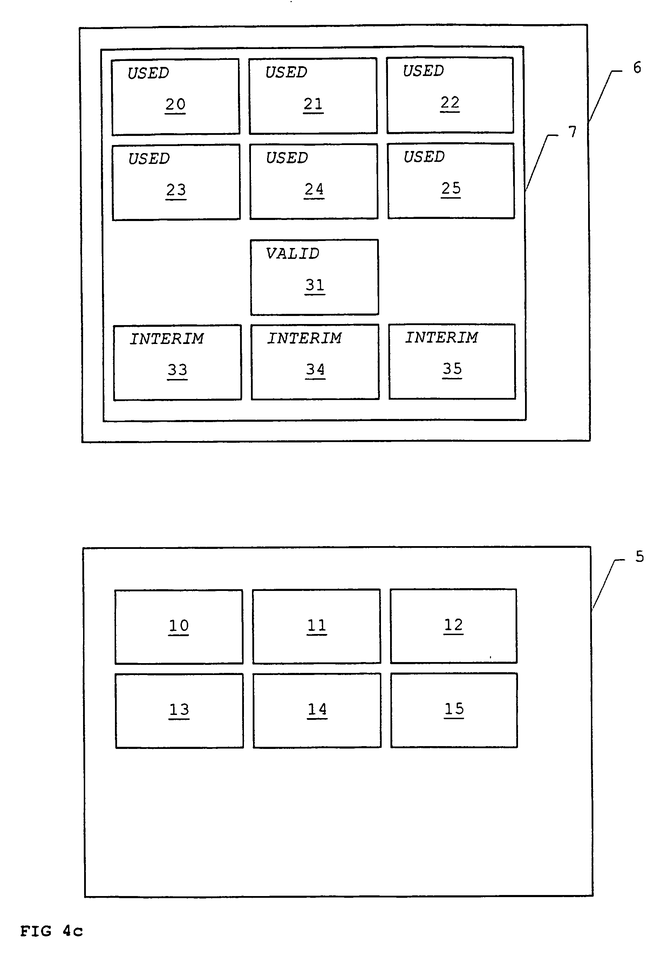

Wurden im Aktualisierungsvorgang alle Datensätze 10 bis 15 im lokalen Speicher 5 des jeweiligen Automatisierungsgerätes 3 betrachtet und liegt mindestens ein neu geschriebener Datensatz 31, 33, 34, 35 mit dem Attribut INTERIM vor, wird das Attribut eines der neu geschriebenen Datensätze 31, 33, 34, 35 auf den Wert VALID gesetzt. Der dabei ausgewählte Datensatz 31 wird im Folgenden zur Unterscheidung als Startdatensatz 31 bezeichnet. FIG 4c zeigt diesen Zustand im Flash-Speicher 6. Das Attribut des Startdatensatzes 31 wurde vom Wert INTERIM (FIG 4b) auf den Wert VALID gesetzt.

Als nächstes wird für alle neu geschriebenen Datensätze 31, 33, 34, 35, die das Attribut INTERIM tragen, der zugehörige alte Datensatz 20 bis 25 mit dem Attribut 20" bis 25" USED gesucht. Für jedes dieser Pärchen erfolgt eine Umwandlung der jeweiligen Attribute.

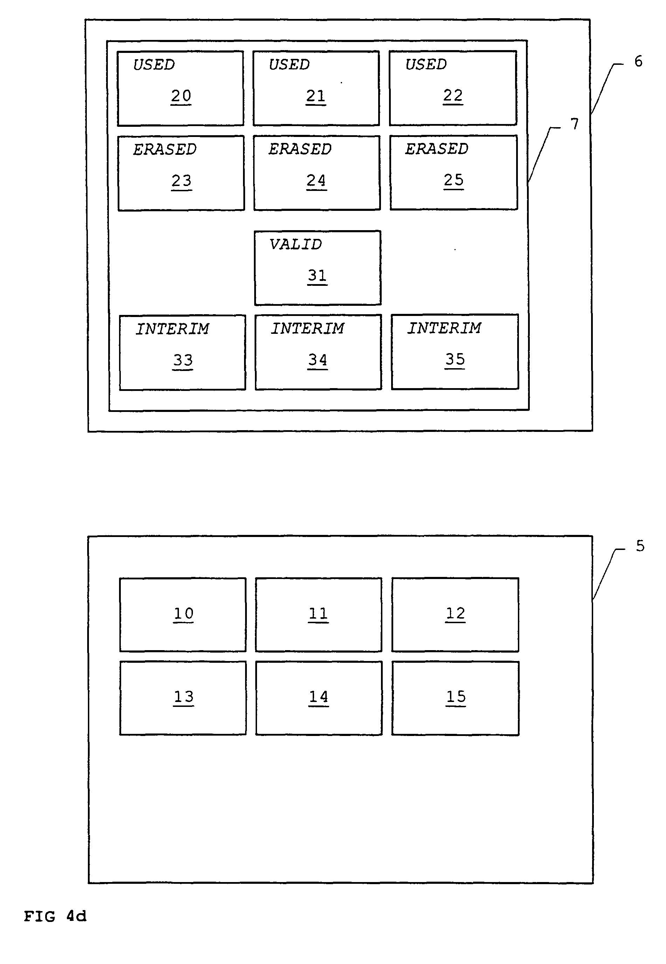

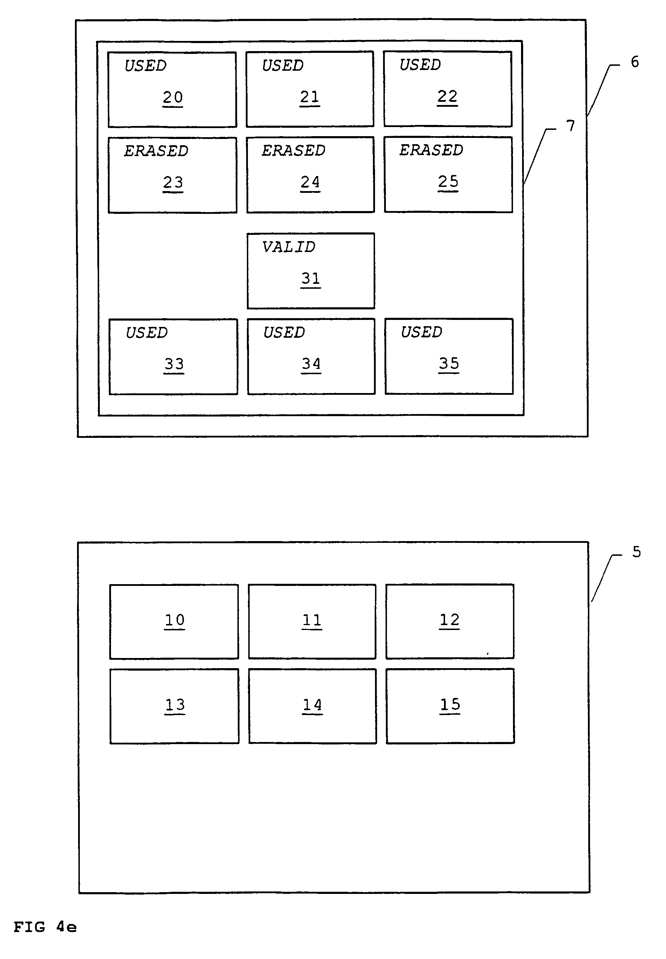

FIG 4d zeigt den Zustand im Flash-Speicher 6, nachdem zuerst bei jedem alten Datensatz 20 bis 25 das Attribut vom Wert USED zum Wert ERASED geändert wurde. FIG 4e zeigt den Zustand im Flash-Speicher 6, nachdem anschließend bei jedem neu geschriebenen Datensatz 31, 33, 34, 35 das Attribut vom Wert INTERIM auf den Wert USED geändert wurde.

Abschließend wird zum Startdatensatz 31 der zugehörige alte Datensatz 21 mit dem Attribut USED gesucht. Für dieses Pärchen erfolgt gleichfalls die Umwandlung der jeweiligen Attribute.

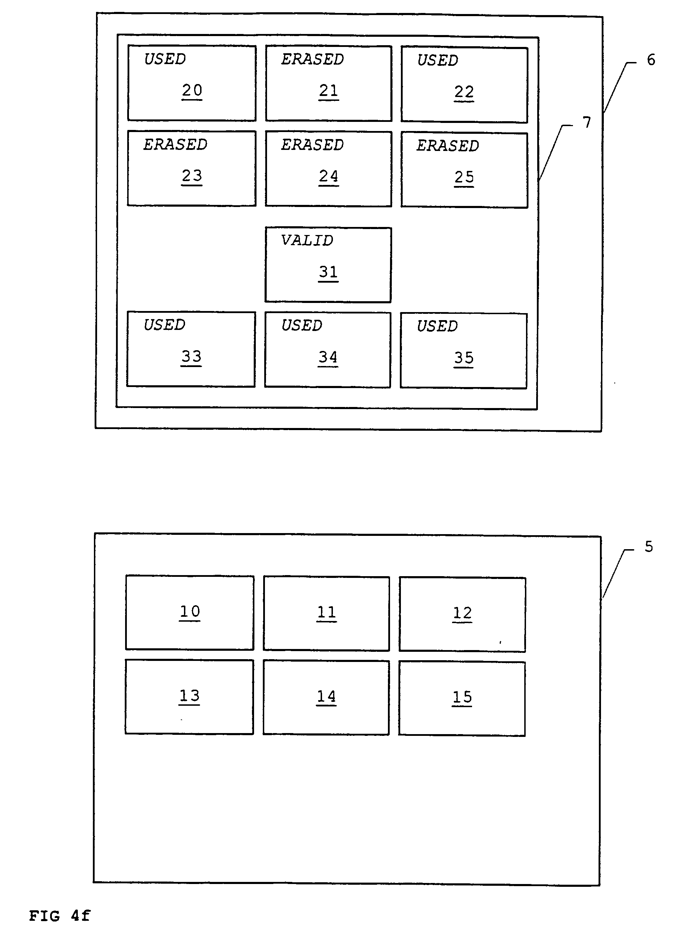

FIG 4f zeigt den Zustand im Flash-Speicher 6, nachdem beim entsprechenden alten Datensatz 21 das Attribut vom Wert USED zum Wert ERASED geändert wurde.

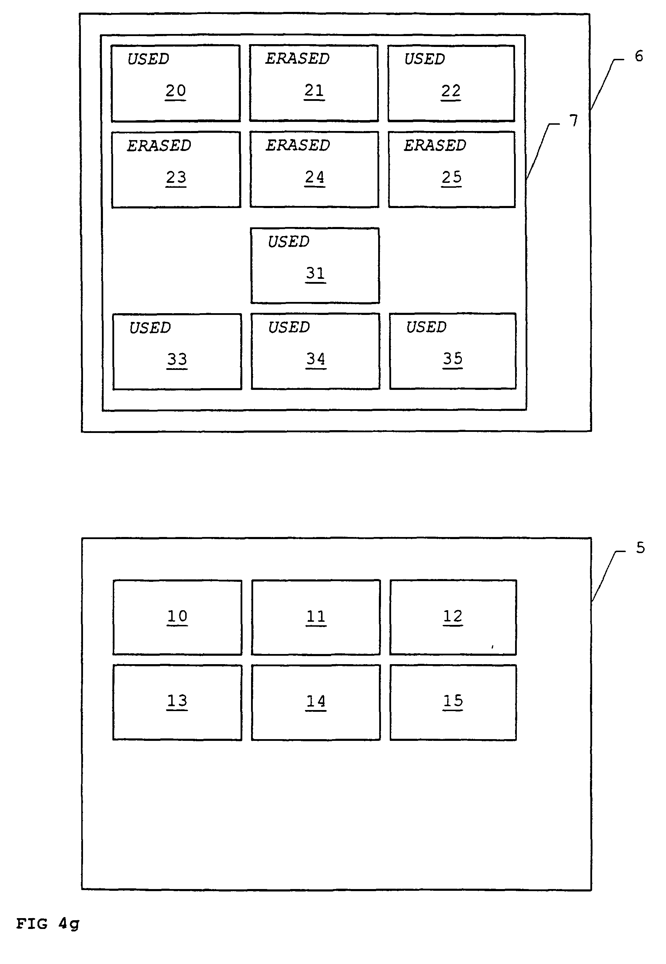

FIG 4g zeigt den Zustand im Flash-Speicher 6, nachdem abschließend beim Startdatensatz 31 das Attribut vom Wert VALID auf den Wert USED geändert wurde. Mit dieser Umwandlung der Attribute ist der gesamte Aktualisierungsvorgang erfolgreich abgeschlossen.

Wird der Aktualisierungsvorgang unterbrochen, ist zu jedem Zeitpunkt ein konsistenter Datenpool 7 wiederherstellbar. Solange nämlich während des Aktualisierungsvorgangs nicht ein neu geschriebener Datensatz 31, 33, 34, 35 mit dem Attribut VALID vorliegt, behalten die alten Datensätze 20 bis 25 im Datenpool 7 Gültigkeit. Der Datenpool 7 hat dann einen Zustand wie in FIG 4b dargestellt. Die alten Datensätze 20 bis 25 tragen in dieser Phase alle das Attribut USED. Neu geschriebene Datensätze 31, 33, 34, 35 mit dem Attribut INTERIM werden gelöscht. Dazu wird ihr Attribut auf den Wert ERASED gesetzt.

Wird dagegen der Aktualisierungsvorgang unterbrochen, wenn ein neu geschriebener Datensatz 31, 33, 34, 35 mit dem Attribut VALID vorliegt, haben die neu geschriebenen Datensätze 31, 33, 34, 35 im Datenpool 7 Gültigkeit. Der Datenpool 7 hat dann einen Zustand wie in FIG 4c dargestellt. Der Aktualisierungsvorgang kann beendet werden, ohne dass die Unterbrechung zu einer Inkonsistenz der Daten hätte führen können.

Das beschriebene Verfahren zum Transfer zusammengehöriger Datensätze in einen Zielspeicher zeichnet sich insbesondere dadurch aus, dass stets die Konsistenz der Datensätze gewährleistet ist, weil jeder Datensatz im Zielspeicher ein Attribut aufweist, beim Transfer eines jeden Datensatzes in den Zielspeicher dem jeweiligen Attribut ein definierter Wert zugewiesen wird und nach dem Abschluss des Transfers sämtlicher Datensätze in den Zielspeicher das Attribut eines der neu geschriebenen Datensätze auf einen definierten anderen Wert gesetzt wird. Anhand dieses Attributwechsels ist jederzeit erkennbar, ob der Aktualisierungsvorgang vollständig und fehlerfrei abgeschlossen wurde oder nicht.

## Patentansprüche

1. Verfahren zur Speicherung zusammengehöriger Datensätze in einem Zielspeicher (6), bei dem im Zielspeicher (6) noch alte Datensätze (20 bis 25) einer zurückliegenden Sicherung vorhanden sind, und bei dem im Zielspeicher (6) jeder Datensatz (20 bis 25) ein Attribut (20" bis 25") aufweist,
- wobei das Attribut (20" bis 25") eines jeden alten Datensatzes (20 bis 25) im Zielspeicher (6) entweder einen ersten Wert (USED) oder einen zweiten Wert (ERASED) hat und
- wobei beim Transfer von Datensätzen (10 bis 15) in den Zielspeicher (6) das Attribut eines jeden neu geschriebenen Datensatzes (31, 33, 34, 35) auf einen dritten Wert (INTERIM) gesetzt wird und
- wobei im Anschluss an den Transfer aller Datensätze (10 bis 15) in den Zielspeicher (6) zunächst das Attribut eines der neu geschriebenen Datensätze (31, 33, 34, 35), des Startdatensatzes (31), auf einen vierten Wert (VALID) gesetzt wird, und
- wobei zu jedem neu geschriebenen Datensatz (31, 33, 34, 35) der zugehörige alte Datensatz (21, 23, 24, 25) mit einem Attribut mit dem ersten Wert (USED) gesucht wird und das Attribut des dabei gefundenen alten Datensatzes (21, 23, 24, 25) auf den zweiten Wert (ERASED) sowie das Attribut des jeweils neu geschriebenen Datensatzes (31, 33, 34, 35) auf den ersten Wert (USED) gesetzt wird, und
- wobei erst dann zu jedem zusätzlich zum Startdatensatz (31) verbleibenden neu geschriebenen Datensatz (33, 34, 35) der zugehörige alte Datensatz (23, 24, 25) mit dem Attribut mit dem ersten Wert (USED) gesucht wird und das Attribut des dabei gefundenen alten Datensatzes (23, 24, 25) auf den zweiten Wert (ERASED)
**dadurch, gekennzeichnet,**
**dass** das Attribut des jeweils neu geschriebenen Datensatzes (33, 34, 35) auf den ersten Wert (USED) gesetzt wird, und
- **dass** zuletzt zu dem Startdatensatz (31) der zugehörige alte Datensatz (21) mit dem Attribut mit dem ersten Wert (USED) gesucht wird und das Attribut des dabei gefundenen alten Datensatzes (21) auf den zweiten Wert (ERASED) sowie das Attribut des Startdatensatzes (31) auf den ersten Wert (USED) gesetzt wird.

2. Verfahren nach Anspruch 1, wobei der Transfer eines Datensatzes (10 bis 15) in den Zielspeicher (6) nur dann erfolgt, wenn dieser Unterschiede zu seinem bereits im Zielspeicher (6) gespeicherten Pendant (20 bis 25) aufweist.

3. Verfahren nach Anspruch 2,
- wobei jeder Datensatz (20 bis -25) im Zielspeicher (6) eine Kennung (20' bis 25') aufweist,
- wobei vor dem Transfer eines Datensatzes in den Zielspeicher (6) für diesen gleichfalls eine Kennung gebildet wird, und
- wobei der Transfer des Datensatzes in den Zielspeicher (6) nur erfolgt, wenn die gebildete Kennung von der Kennung (20' bis 25') des bereits im Zielspeicher (6) gespeicherten Pendants (20 bis 25) des zu transferierenden Datensatzes (10 bis 15) abweicht.

4. Verfahren nach Anspruch 1, wobei der Zielspeicher (6) ein Flash-Speicher (6) ist.

5. Verfahren nach Anspruch 4, wobei sich dritte Wert (INTERIM) des Attributs vom vierten Wert (VALID), der vierte Wert (VALID) vom ersten Wert (USED) und der erste Wert (USED) vom zweiten Wert (ERASED) durch eine ganzzahlige Potenz von Zwei unterscheidet.

6. Verfahren nach Anspruch 5, wobei der vierte Wert (VALID) des Attributs in Bezug auf den dritten Wert (INTERIM), der erste Wert (USED) des Attributs in Bezug auf den vierten Wert (VALID) und der zweite Wert (ERASED) des Attributs in Bezug auf den ersten Wert (USED) jeweils um eine ganzzahlige Potenz von Zwei kleiner ist.

7. Verfahren nach Anspruch 5, wobei der vierte Wert (VALID) des Attributs in Bezug auf den dritten Wert (INTERIM), der erste Wert (USED) des Attributs in Bezug auf den vierten Wert (VALID) und der zweite Wert (ERASED) des Attributs in Bezug auf den ersten Wert (USED) jeweils um eine ganzzahlige Potenz von Zwei größer ist.

8. Verfahren nach einem der Ansprüche 1 bis 7,
- wobei die zusammengehörigen Datensätze in einem Datenpool zusammengefasst sind,
- wobei der Datenpool ein Attribut aufweist, und
- wobei die Speicherung zusammengehöriger Datenpools analog zur Speicherung zusammengehöriger Datensätze erfolgt.

## Claims

1. Method for storing related data records in a destination memory (6), in which old data records (20 to 25) of a previous backup are still present in the destination memory (6) and in which each data record (20 to 25) in the destination memory (6) has an attribute (20" to 25"),
- with the attribute (20" to 25") of each old data record (20 to 25) in the destination memory (6) having either a first value (USED) or a second value (ERASED) and
- with the attribute of a each newly written data record (31, 33, 34, 35) being set to a third value (INTERIM) when data records (10 to 15) are transferred into the destination memory (6) and
- with, following the transfer of all data records (10 to 15) into the destination memory (6), the attribute of one of the newly written data records (31, 33, 34, 35), of the start data record (31) being initially set to a fourth value (VALID), and
- with, for each newly written data record (31, 33, 34, 35), the related old data record (21, 23, 24, 25) with an attribute with the first value (USED) being sought and the attribute of the old data record (21, 23, 24, 25) found in such cases being changed to the second value (ERASED) as well as the attribute of the respective newly written data record (31, 33, 34, 35) being set to the first value (USED), and
- with only then for each newly written data record (33, 34, 35) remaining in addition to the start data record (31), the related old data record (23, 24, 25) with the attribute with the first value (USED) being sought and the attribute of the old data record found in this case (23, 24, 25) being set to the second value (ERASED
**characterized in that**,
- the attribute of the respective newly written data record (33, 34, 35) is set to the first value (USED), and
- lastly the related old data record (21) with the attribute with the first value (USED) is sought for the start data record (31) and the attribute of the old data record (21) found in this case is set to the second value (ERASED) as well as the attribute of the start data record (31) to the first value (USED).

2. Method in accordance with claim 1, with the transfer of a data record (10 to 15) into the destination memory (6) only taking place if this record differs from its pendant (20 to 25) already stored in the destination memory (6).

3. Method in accordance with claim 2,
- with each data record (20 to 25) in the destination memory (6) having an identifier (20' to 25'),
- with, before a data record is transferred into the destination memory (6) an identifier is likewise formed for this, and
- with the data record only being transferred into the destination memory (6) if the identifier formed differs from the identifier (20' to 25') of the pendant (20 to 25) already stored in the destination memory (6) of the data record (10 to 15) to be transferred.

4. Method in accordance with claim 1, with the destination memory (6) being a flash memory (6).

5. Method in accordance with claim 4, with the third value (INTERIM) of the attribute differing from the fourth value (VALID), the fourth value (VALID) from the first value (USED) and the first value (USED) from second value (ERASED) by an integer power of two.

6. Method in accordance with claim 5, with the fourth value (VALID) of the attribute being smaller in relation to the third value (INTERIM), the first value (USED) of the attribute in relation to the fourth value (VALID) and the second value (ERASED) of the attribute in relation to the first value (USED) in each case by an integer power of two.

7. Method in accordance with claim 5, with the fourth value (VALID) of the attribute being greater in relation to the third value (INTERIM), the first value (USED) of the attribute in relation to the fourth value (VALID) and the second value (ERASED) of the attribute in relation to the first value (USED) in each case by an integer power of two.

8. Method in accordance with one of the claims 1 to 7,
- with the related data records being combined into a data pool,
- with the data pool having an attribute, and
- with related data pools being stored in a similar fashion to related data records.

## Revendications

1. Procédé de mémorisation d'ensembles de données associés dans une mémoire cible ( 6 ), dans lequel il y a encore dans la mémoire cible ( 6 ) d'anciens ensembles de données ( 20 à 25 ) d'une sauvegarde précédente, et dans lequel dans la mémoire cible chaque ensemble de données ( 20 à 25 ) possède un attribut ( 20'' à 25'' ),
- l'attribut ( 20'' à 25'' ) de chaque ancien ensemble de données ( 20 à 25 ) dans la mémoire cible ( 6 ) ayant une première valeur ( USED ) ou une deuxième valeur ( ERASED ) et
- lors du transfert d'ensembles de données ( 10 à 15 ) dans la mémoire cible ( 6 ), l'attribut de chaque nouvel ensemble de données ( 31, 33, 34, 35 ) enregistré étant mis à une troisième valeur ( INTERIM ) et
- à la suite du transfert de tous les ensembles de données ( 10 à 15 ) dans la mémoire cible, l'attribut de l'un des nouveaux ensembles de données ( 31, 33, 34, 35 ) enregistrés, l'ensemble de données de départ ( 31 ), étant mis d'abord à une quatrième valeur ( VALID ), et
- pour chaque nouvel ensemble de données ( 31, 33, 34, 35 ) enregistré, l'on recherche l'ancien ensemble de données associé ( 21, 23, 24, 25 ) dont l'attribut a la première valeur ( USED ) et l'attribut de l'ancien ensemble de données ( 21, 23, 24, 25 ) alors trouvé étant mis à la deuxième valeur ( ERASED ) ainsi que l'attribut du nouvel ensemble de données ( 31, 33, 34, 35 ) enregistré étant mis à la première valeur ( USED ), et
- c'est seulement ensuite que pour chaque nouvel ensemble de données enregistré ( 33, 34, 35 ), restant en plus de l'ensemble de données de départ ( 31 ), l'on recherche l'ancien ensemble de données associé ( 23, 24, 25 ) dont l'attribut est à la première valeur ( USED ) et que l'attribut de l'ancien ensemble de données ( 23, 24, 25 ) alors trouvé est mis à la deuxième valeur,
**caractérisé en ce que**
- l'attribut du nouvel ensemble de données enregistré ( 33, 34, 35 ) est mis à la première valeur ( USED ), et
- enfin, pour l'ensemble de données de départ ( 31 ), l'on recherche l'ancien ensemble de données associé ( 21 ) dont l'attribut a la première valeur ( USED ) et l'attribut de l'ancien ensemble de données ( 21 ) alors trouvé est mis à la deuxième valeur ( ERASED ) ainsi que l'attribut de l'ensemble de données de départ ( 31 ) est mis à la première valeur ( USED ).

2. Procédé selon la revendication 1, dans lequel le transfert d'un ensemble de données ( 10 à 15 ) dans la mémoire cible ( 6 ) n'est effectué que si celui-ci présente des différences par rapport à son pendant ( 20 à 25 ) déjà mémorisé dans la mémoire cible ( 6 ).

3. Procédé selon la revendication 2, dans lequel
- chaque ensemble de données ( 20 à 25 ) dans la mémoire cible ( 6 ) possède un identifiant ( 20' à 25' ),
- avant le transfert d'un ensemble de données dans la mémoire cible ( 6 ), on forme également pour celui-ci un identifiant, et
- le transfert de l'ensemble de données dans la mémoire cible ( 6 ) n'est effectué que si l'identifiant formé diffère de l'identifiant ( 20' à 25' ) du pendant ( 20 à 25 ), déjà mémorisé dans la mémoire cible, de l'ensemble de données ( 10 à 15 ) à transférer.

4. Procédé selon la revendication 1, dans lequel la mémoire cible ( 6 ) est une mémoire Flash ( 6 ).

5. Procédé selon la revendication 4, dans lequel la troisième valeur ( INTERIM ) diffère de la quatrième valeur ( VALID ), la quatrième valeur ( VALID ) diffère de la première valeur ( USED ) et la première valeur ( USED ) diffère de la deuxième valeur ( ERASED ), d'une puissance entière de deux.

6. Procédé selon la revendication 5, dans lequel la quatrième valeur ( VALID ) de l'attribut est inférieure à la troisième valeur ( INTERIM ), la première valeur ( USED ) de l'attribut est inférieure à la quatrième valeur ( VALID ) et la deuxième valeur ( ERASED ) de l'attribut est inférieure à la première valeur ( USED ), respectivement d'une puissance entière de deux.

7. Procédé selon la revendication 5, dans lequel la quatrième valeur ( VALID ) de l'attribut est supérieure à la troisième valeur ( INTERIM ), la première valeur ( USED ) de l'attribut est supérieure à la quatrième valeur ( VALID ) et la deuxième valeur ( ERASED ) de l'attribut est supérieure à la première valeur ( USED ), respectivement d'une puissance entière de deux.

8. Procédé selon l'une des revendications 1 à 7, dans lequel
- les ensembles de données associés sont rassemblés dans un regroupement de données,
- le regroupement de données possède un attribut, et
- la mémorisation de regroupements de données associés est effectuée de façon analogue à la mémorisation d'ensembles de données associés.
